# EUROPÄISCHE PATENTSCHRIFT

(11) **EP 1 238 312 B1**
(45) Veröffentlichungstag und Bekanntmachung des Hinweises auf die Patenterteilung: **02.08.2006**
(21) Anmeldenummer: 00976042.2
(22) Anmeldetag: 17.11.2000
(51) Int. Cl.: G03F 7/11, G03F 7/038, H01L 21/768

(54) **VERWENDUNG VON POLYIMID FÜR HAFTSCHICHTEN, LITHOGRAPHISCHES VERFAHREN ZUR HERSTELLUNG VON MIKROBAUTEILEN SOWIE VERFAHREN ZUR HERSTELLUNG VON VERBUNDMATERIAL**
USE OF POLYIMIDE FOR ADHESIVE LAYERS, LITHOGRAPHIC METHOD FOR PRODUCING MICROCOMPONENTS AND METHOD FOR PRODUCING COMPOSITE MATERIAL
UTILISATION DE POLYIMIDE POUR DES COUCHES ADHESIVES, PROCEDE LITHOGRAPHIQUE POUR PRODUIRE DES MICROCOMPOSANTS ET PROCEDE POUR PRODUIRE UN MATERIAU COMPOSITE

(30) Priorität: 19.11.1999 DE 19955969
(43) Veröffentlichungstag der Anmeldung: 11.09.2002
(73) Patentinhaber: INSTITUT FÜR MIKROTECHNIK MAINZ GmbH, 55129 Mainz-Hechtsheim (DE)
(72) Erfinder: SCHMITZ, Felix, 55118 Mainz (DE); NIENHAUS, Matthias, 55127 Mainz (DE)
(74) Vertreter: Fuchs Mehler Weiss & Fritzsche
(86) Internationale Anmeldenummer: PCT/EP2000/011448
(87) Internationale Veröffentlichungsnummer: WO 2001/037050

(56) Entgegenhaltungen:
- EP-A- 0 067 066
- EP-A- 0 394 638
- EP-A- 0 623 852
- EP-A- 0 718 696

## Beschreibung

Die Erfindung betrifft die Verwendung von Polyimid oder Polyimidmischungen sowie ein lithographisches Verfahren zur Herstellung von Mikrobauteilen mit Bauteilstrukturen im sub-Millimeterbereich, bei dem auf eine metallische Schicht eine strukturierbare Haftschicht und auf die Haftschicht eine Schicht aus photostrukturierbarem Epoxyharz aufgebracht wird, das Epoxyharz mittels selektiver Belichtung und Herauslösen der unbelichteten Bereiche strukturiert wird und nach dem Entfernen der Haftschicht aus den Zwischenräumen zwischen den Harzstrukturen die Zwischenräume mittels eines galvanischen Verfahrens mit Metall aufgefüllt werden. Femer betrifft die Erfindung ein Verfahren zur Herstellung von Verbundmaterial aus Substrat, Metall und photostrukturierbaren Epoxyharzen.

Bei lithographischen Verfahren werden unterschiedliche Polymere als Resistmaterialien verwendet, wobei unter Resistmaterialien solche verstanden werden, die mittels Belichtung strukturierbar sind.

PMMA als Resistmaterial ist zwar am weitesten verbreitet, hat aber den Nachteil, daß zur Herstellung von Mikrostrukturen mit einem Aspekfirerhältnis >10 für die Belichtung Synchrotronstrahlung eingesetzt werden muß, was einerseits sehr zeitaufwendig und andererseits mit hohen Kosten verbunden ist.

Es wurde daher versucht, auf photostrukturierbare Resistmaterialien überzugehen, die beispielsweise mittels UV-Licht strukturierbar sind. Diese Materialien haben jedoch in der Regel den Nachteil, daß keine großen Aspektverhältnisse erzielt werden können.

Ein Resistmaterial, das sowohl große Aspektverhältnisse von beispielsweise 15 und darüber ermöglicht als auch mittels UV-Licht strukturiert werden kann, ist Epoxyharz, insbesondere ein Epoxyderivat eines Bis-Phenol-A-Novolacs, das bisher bereits in der Halbleitertechnik verwendet wurde. Dieses Resistmaterial wird als SU-8- Resistmaterial (Handelsname der Shell Chemical) verwendet, das beispielsweise in J. Micromechanics, Microengineering 7(1997) S. 121-124 beschrieben wird. Große Aspektverfiältnisse können dadurch hergestellt werden, daß aufgrund der Vernetzung bei der Belichtung eine Veränderung des Brechungsindex dieses Materials erzeugt wird, so daß aus dem Resistmaterial Strukturen mit Wellenleitereigenschaften hergestellt werden können. Man erhält dadurch bei der Belichtung mittels Masken letztendlich senkrechte Wände, die beim Herausätzen der unbelichteten Bereiche erhalten bleiben.

SU-8-Material hat jedoch den Nachteil, daß es nicht auf allen Metallen bzw. Silizium haftet, die üblicherweise als Startschichten für galvanische Abscheidungsverfahren bzw. als Trägermaterialien verwendet werden.

Während SU-8 auf Aluminium gut haftet, hängt die Haftung auf Gold bzw. Nickel von der Größe der Mikrostruktur, d.h. von den lateralen Abmessungen des Mikrobauteils, ab.

Bei Kupfer, Silber, Chrom und Nickel ist die Haftung weniger gut, so daß eine Haftschicht zwischen dem Metall und dem SU-8-Resistmaterial erforderlich ist.

Aus Proc. SPIE Vol. 36808-65 Paris, France, 30. März bis 1. April 1999 "Micromachining and Microfabrication" mit dem Titel "Design and realization of a penny-shaped micromotor" von M. Nienhaus et al. ist es bekannt, zwischen der Kupferstartschicht und dem SU-8-Material ein Haftvermittler (Bonding agent), beispielsweise Hexamethyldisilazan (HMDS), vorzusehen, was jedoch den Nachteil hat, daß der Haftvermittler besonders dünn ist und hierdurch die Haftung nicht in allen Fällen zufriedenstellend ist.

Die EP-A-0718696 beschreibt Polyimidschichten mit Dicken zwischen 6 und 13 µm. Derartige Haftschichten führen während der Trocknung und Vernetzung des Polyimids zu Spannungen in der Haftschicht, was zu partiellen Ablösungen führen kann.

Es ist daher Aufgabe der Erfindung, eine Haftschicht zu finden, die für photostrukturierbare Epoxyharze, insbesondere für SU-8-Resistmaterial, geeignet ist, die genannten Nachteile vermeidet und ein Ablösen des Resistmaterials verhindert. Es ist auch Aufgabe der Erfindung, ein Verfahren zur Herstellung von Verbundmaterial und ein lithographisches Verfahren zur Herstellung von Mikrobauteilen bereitzustellen, bei dem keine Haftungsprobleme bezüglich des Resistmaterials auftreten.

Es hat sich überraschend herausgestellt, daß Polyimid oder Polyimidmischungen für eine Haftschicht mit einer Dicke < 1 µm zwischen photostrukturierbaren Epoxyharzen und Metall oder Silizium hervorragend geeignet ist. Bei diesen geringen Dicken von <1 µm, vorzugsweise von 500 bis 900 nm ist die Haftschicht vemachlässigbaren Spannungen unterworfen.

Die Haftung ist auch bei Mikrobauteilen mit lateralen Abmessungen im mm- und cm-Bereich gut.

Vorzugsweise wird photostrukturierbares Polyimid verwendet.

Als Polyimide bzw. photostrukturierbare Polyimide kommen solche in Frage, die in TRIP. Vol. 3, Nr. 8, August 1995, S. 262-271, "The Synthesis of Soluble Polyimides" von Samual J. Huang und Andrea E. Hoyt sowie in SPIE Vol. 1925, S. 507-515 "Base-Catalyzed Photosensitive Polyimide" von Dennis R. McKean et al. beschrieben werden. Mischungen dieser Polyimide sind ebenfalls als Haftschicht **geeignet.**

Das lithographische Verfahren zur Herstellung von Mikrobauteilen mit Bauteilstrukturen im sub-Millimeterbereich bei dem auf eine metallische Schicht eine strukturierbare Haftschicht und auf die Haftschicht eine Schicht aus photostrukturierbarem Epoxyharz aufgebracht wird, das Epoxyharz mittels selektiver Belichtung und Herauslösen der unbelichteten Bereiche strukturiert wird und nach dem Entfernen der Haftschicht aus den Zwischenräumen zwischen den Harzstrukturen die Zwischenräume mittels eines galvanischen Verfahrens mit Metall aufgefüllt werden, sieht vor, daß eine Haftschicht aus Polyimid oder einer Mischung von Polyimiden, gegebenenfalls mit Zusätzen von Haftzusätzen oder Photoinitiatoren, mit einer Dicke < 1 µm, verwendet wird.

Da die Metallschicht, auf der das Epoxyharz über die Haftschicht aufgebracht wird, gleichzeitig die Startschicht für den nachfolgenden galvanischen Abscheideprozeß darstellt, müssen diejenigen Bereiche, wo Metalle abgeschieden werden sollen, freigelegt werden.

Gemäß der ersten bevorzugten Ausführungsform werden nach der Strukturierung des Epoxyharzes die freiliegenden Bereiche der Haftschicht zur Freilegung der metallischen Startschicht mittels Plasmaätzen entfernt.

Gemäß einer bevorzugten Ausführungsform wird als Polyimid ein photostrukturierbares Polyimid verwendet.

Gemäß einer zweiten Alternative des lithographischen Verfahrens von Mikrobauteilen mit Bauteilstrukturen im sub-Millimeterbereich, bei dem auf eine metallische Schicht eine strukturierbare Haftschicht und auf die Haftschicht eine Schicht aus photostrukturierbarem Epoxyharz aufgebracht wird, das Epoxyharz mittels selektiver Belichtung und Herauslösen der unbelichteten Bereiche strukturiert wird und die Zwischenräume zwischen den Harzstrukturen mittels eines galvanischen Verfahrens mit Metall aufgefüllt werden, ist vorgesehen, dass die Haftschicht vor dem Aufbringen des Epoxyharzes selektiv belichtet wird und die unbelichteten Bereiche entfernt werden, daß anschließend das Epoxyharz vollflächig auf die Haftschicht und die freiliegende metallische Schicht aufgebracht wird, daß im wesentlichen diejenigen Bereiche des Epoxyharzes belichtet werden, unter denen sich die Haftschicht befindet, und daß anschließend die unbelichteten Bereiche des Epoxyharzes zur Freilegung der Metallschicht entfernt werden.

Dies setzt voraus, daß die Belichtungen sowohl der Haftschicht als auch der Resistschicht aus dem Epoxyharz an denselben Stellen durchgeführt werden.

Hierzu wird für die beiden Belichtungsprozesse vorzugsweise mit derselben Maske gearbeitet.

Es besteht auch die Möglichkeit, sogenannte Laserdirektschreiber zu verwenden, deren Laserstrahl über das zu belichtende Objekt geführt wird. Bei der Verwendung solcher Laserdirektschreiber werden die Belichtungen der Haftschicht und der Epoxyharzschicht jeweils mit derselben Linienführung des Laserstrahls durchgeführt.

Das Verfahren zur Herstellung von Verbundmaterial aus Substrat, Metall und photostrukturierbaren Epoxyharzen ist dadurch gekennzeichnet, daß auf das Substrat eine Metallschicht mit Mikro-Topographie aufgebracht wird und daß auf die Metallschicht als Haftschicht eine Polyimidschicht mit einer Dicke < 1 µm aufgebracht wird, auf die anschließend das Epoxyharz aufgetragen wird.

Unter Mikro-Topographie werden Rauhigkeiten im Nanometerbereich verstanden. Die Verbesserung der Haftung wird dadurch erreicht, daß Spannungen der Polyimidschicht in der rauhen Oberfläche kompensiert werden.

Das Substrat kann beispielsweise aus Silizium, Glas, Kunststoff oder Keramik bestehen und die Metallschicht/en kann/können eine Titan-, Kupfer-, Nickel- und/oder Silberschicht sein. Wenn z.B. zwei Materialien aufgebracht werden, wird zunächst eine Titan- und anschließend die Kupferschicht aufgebracht, wobei die Schichtdicken dieser Metallschichten vorzugsweise zwischen 100 und 500 nm liegen. Das Aufbringen der Metallschichten kann mittels Sputterprozessen oder Aufdampfen erfolgen.

Vorzugsweise wird die Metallschicht vor dem Aufbringen des Polyimidmaterials bei 200°C bis 300°C für eine Zeitdauer von 10 bis 60 min dehydriert. Bevorzugte Werte liegen bei 240°C bis 260°C und 25 bis 35 min.

Vorzugsweise wird die Polyimidschicht mittels eines Spincoat-Prozesses auf die dehydrierte Metallschicht aufgetragen. Nach der Dehydrierung sind keine weiteren Verfahrensschritte vor dem Aufbringen der Polyimidschicht erforderlich.

Vorzugsweise wird auf die Metallschicht ein Precurser-Material aufgebracht, das anschließend einer Wärmebehandlung zur Ausbildung des Polyimids unterworfen wird. Unter einem Precurser-Material werden Monomermatedalien aus vorzugsweise Polyamidkarbonsäuren verwendet, wobei durch eine nachfolgende Wärmebehandlung eine Cyclisierung bzw. Ringsynthese bewirkt wird, so daß Polyimid entsteht.

Die Wärmebehandlung wird vorzugsweise 0,5 bis 2 min bei 80°C bis 100°C und 2 bis 4 min bei 100°C bis 120°C durchgeführt.

Vorzugsweise wird UV-Licht als Flutbelichtung zum Starten des Vemetzungsprozesses eingesetzt. Eine weitere thermische Behandlung, vorzugsweise bei 100°C bis 110°C, dient der weiteren Vemetzung. Ein anschließendes Entwickeln mit z.B. Butyl-Acetat wird vorzugsweise zum Herauslösen der nichtbelichteten bzw. der nichtvemetzten Bereiche durchgeführt.

Beispielhafte Ausführungsformen der Erfindung werden nachfolgend anhand der Zeichnungen näher erläutert. Es zeigen:
- Fign. 1a-1e: schematisch die Herstellung eines Mikrobauteils mittels eines lithographischen Verfahrens unter Verwendung von Polyimid-Haftschichten gemäß einer ersten Ausführungsform und die
- Fign. 2a-2f: ein lithographisches Verfahren gemäß einer zweiten Ausführungsform.

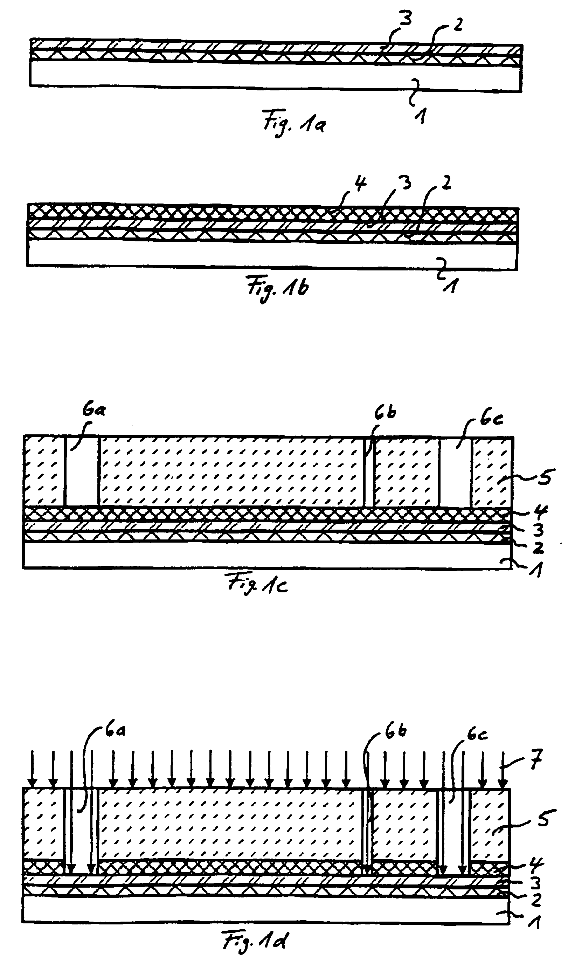

In den Fign. 1a bis le ist das Herstellungsverfahren eines Mikrobauteils mit metallischen Bauteilstrukturen gemäß einer ersten Ausführungsform dargestellt. Auf ein Substrat 1 aus Silizium wird zunächst eine Titanhaftschicht 2 der Dicke 100 nm aufgetragen. Auf diese Titanhaftschicht 2 wird die Kupferstartschicht 3 mit einer Dicke von 1 µm aufgebracht.

In der Fig. 1b ist in einem weiteren Verfahrensschritt die Haftschicht 4 aus Polyimid oder einer Polyimidmischung vollflächig aufgetragen.

In der Fig. 1c ist eine Resistschicht 5 aus SU-8-Resistmaterial aufgetragen, die bereits mittels UV-Licht belichtet wurde, wobei die unbelichteten Bereiche entfernt wurden. In der Fig. 1c sind daher bereits freigelegte Strukturen 6a,b und c zu sehen. Am Grund dieser Strukturen 6a,b,c befindet sich aufgrund der zuvor durchgeführten vollflächigen Auftragung noch die Polyimid-Haftschicht 4, so daß die darunterliegende Kupferstartschicht 3 nicht zugänglich ist.

Um die Kupferstartschicht 3 freizulegen, wird in einem weiteren Verfahrensschritt, der in der Fig. 1d dargestellt ist, mittels einer Plasmabehandlung (Plasma 7) die Schicht 3 im Bereich der Strukturen 6a,b und c gezielt entfernt. Die Kupferstartschicht steht anschließend zur Verfügung, so daß die Strukturen 6a,b,c mit Metall zur Bildung eines Mikrobauteils mit metallischen Bauteilstrukturen galvanisch aufgefüllt werden können.

Der Prozeßablauf für die Herstellung der Haftschicht 4 ist wie folgt:
- Substrat 1:: 5"-Si-Wafer mit aufgedampfer 100 nm-Ti-Haftschicht und darauf 500 nm Cu-Startschicht
- Dehydrieren:: Im Vakuumofen bei 250°C 30 min
- Spincoaten:: Bei 6250 U/min mit 2 ml "Probimide 7000" (Warenzeichen der Arch Chemical, USA) mit 24 % Gewichtsanteil in NMP (n-Mettryl-Pyrrolidon) gelöst
- Trocknung:: 1 min bei 90°C und 3 min bei 110°C auf geheizter Platte zur Verbesserung der Vernetzung
- Belichtung:: Flutbelichtung ohne Maske mit 100 mJ/cm³
- Gegebenenfalls thermische Behandlung (post exposure bake):: bei 100°C bis 110°C
- Entwickeln:: mit Butyl-Acetat
- Imidisierung:: unter N₂ - Atmosphäre bei 380°C 60 min
- Resultierende Schichtdicke:: ca. 800 nm

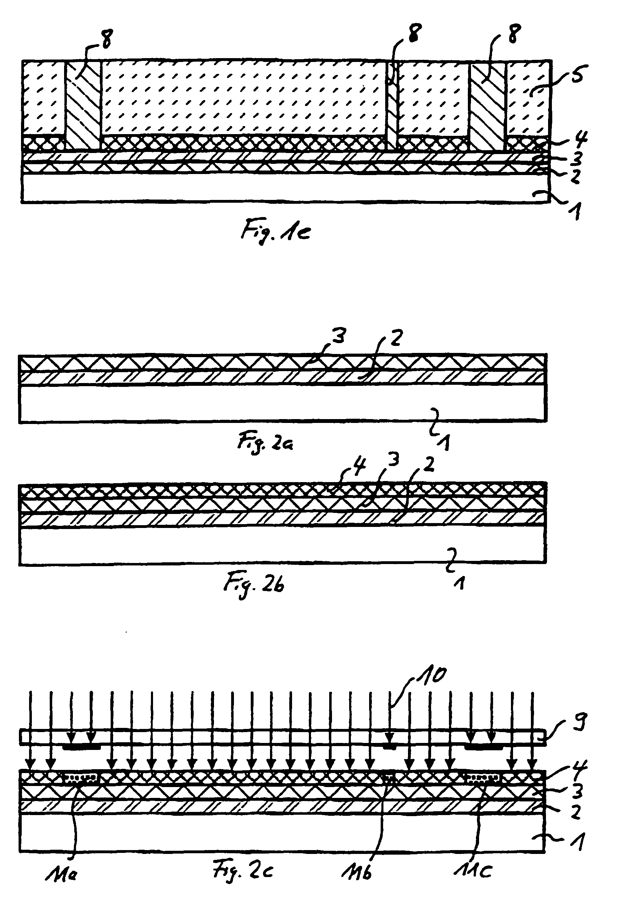

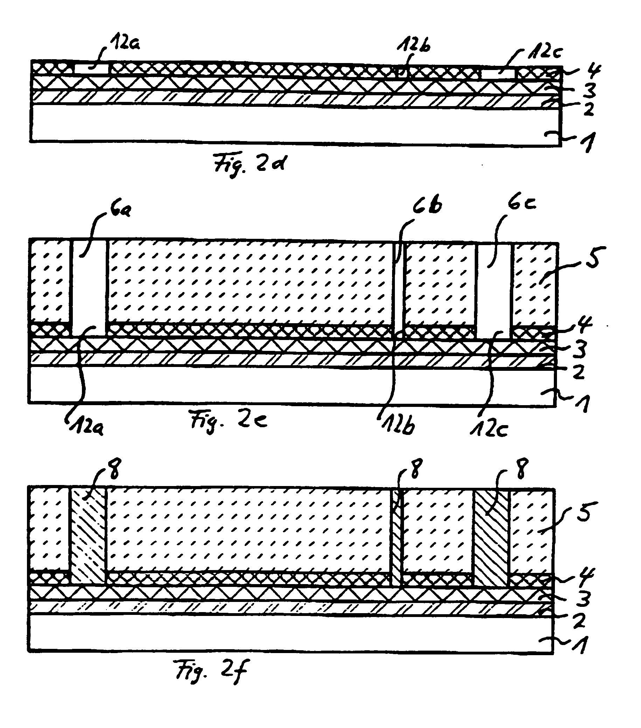

In den Fign. 2a bis 2f ist eine weitere Ausführungsform zur Herstellung metallischer Mikrobauteile schematisch dargestellt. Die Fign. 2a und 2b zeigen dieselben Verfahrensschritte wie die Fign. 1a und 1b mit der Ausnahme, daß anstatt einer Cu-Startschicht eine Au-Startschicht 3 aufgetragen wurde.

Gemäß der Fig. 2c wird eine Belichtung der Polyimidschicht 4 mittels UV-Licht 10 (200 mJ/cm³) und einer Maske 9 durchgeführt. Es entstehen dadurch unbelichtete Bereiche 11a, 11b, 11c in der Polyimidschicht, die in einem nachfolgenden Schritt, der in der Fig. 2d gezeigt ist, entfernt werden. Durch die so geschaffenen Polyimidstrukturen 12a,b,c werden die Flächen der Startschicht 3 freigelegt, wo die galvanische Abscheidung stattfinden soll.

Im nachfolgenden Schritt, der in der Fig. 2e gezeigt ist, wird eine Schicht 5 aus SU-8-Material aufgebracht, wobei mittels derselben Maske 9 eine Belichtung mit UV-Licht durchgeführt wird. Die unbelichteten Bereiche der Schicht 5 werden ebenfalls entfemt, so daß die Strukturen 6a,b,c freigelegt werden. Da mit derselben Maske 9 gearbeitet wurde, liegen die Strukturen 12a,b,c und 6a,b,c übereinander. Es kann somit unmittelbar der galvanische Abscheideprozeß angeschlossen werden, der zum Auffüllen dieser Strukturen mit Metall führt, wie dies in der Fig. 2f dargestellt ist.

### Bezugszeichen

- 1: Substrat
- 2: Tltanhaftschicht
- 3: Kupferstartschicht
- 4: Polyimidschicht
- 5: Resistschicht
- 6a,b,c: freigelegte Struktur
- 7: Plasma
- 8: Metall
- 9: Maske
- 10: UV-Licht
- 11a,b,c: unbelichtete Bereiche der Polyimidschicht
- 12a,b,c: freigelegte Polyimidstruktur

## Patentansprüche

1. Verwendung von Polyimid oder Polyimidmischungen für eine Haftschicht mit einer Dicke < 1 *µ*m zwischen photostrukturierbaren Epoxyharzen und Metall oder Silizium.

2. Verwendung nach Anspruch 1, wobei photostrukturierbares Polyimid verwendet wird.

3. Lithographisches Verfahren zur Herstellung von Mikrobauteilen mit Bauteilstrukturen im sub-Millimeterbereich, bei dem auf eine metallische Schicht eine strukturierbare Haftschicht und auf die Haftschicht eine Schicht aus photostrukturierbarem Epoxyharz aufgebracht wird, das Epoxyharz mittels selektiver Belichtung und Herauslösen der unbelichteten Bereiche strukturiert wird und nach dem Entfernen der Haftschicht aus den Zwischenräumen zwischen den Harzstrukturen die Zwischenräume mittels eines galvanischen Verfahrens mit Metall aufgefüllt werden, **dadurch gekennzeichnet, daß** eine Haftschicht aus Polyimid oder eine Polyimidmischung mit einer Dicke < 1 *µ*m verwendet wird.

4. Verfahren nach Anspruch 3, **dadurch gekennzeichnet, daß** nach der Strukturierung des Epoxyharzes die freiliegende Haftschicht zum Freilegen der Metallschicht mittels Plasmaätzen entfernt wird.

5. Verfahren nach Anspruch 3, **dadurch gekennzeichnet, daß** als Polyimid ein photostrukturierbares Polyimid verwendet wird.

6. Lithographisches Verfahren zur Herstellung von Mikrobauteilen mit Bauteilstrukturen im sub-Millimeterbereich, bei dem auf eine metallische Schicht eine strukturierbare Haftschicht und auf die Haftschicht eine Schicht aus photostrukturierbarem Epoxyharz aufgebracht wird, das Epoxyharz mittels selektiver Belichtung und Herauslösen der unbelichteten Bereiche strukturiert wird und die Zwischenräume zwischen den Harzstrukturen mittels eines galvanischen Verfahrens mit Metall aufgefiillt werden, **dadurch gekennzeichnet, daß** eine Haftschicht aus photostrukturierbarem Polyimid oder einer photostrukturierbaren Polyimidmischung mit einer Dicke < 1 µm verwendet wird und
- daß die Haftschicht vor dem Aufbringen des Epoxyharzes selektiv belichtet wird und die unbelichteten Bereiche entfernt werden,
- daß anschließend das Epoxyharz vollflächig auf die Haftschicht und die freiliegende metallische Schicht aufgebracht wird,
- daß im wesentlichen diejenigen Bereiche des Epoxyharzes belichtet werden, unter denen sich die Haftschicht befindet, und
- daß anschließend die unbelichteten Bereiche des Epoxyharzes zur Freilegung der Metallschicht entfernt werden.

7. Verfahren nach Anspruch 6, **dadurch gekennzeichnet, daß** die Belichtungen der Haftschicht und der Epoxyharzschicht mit derselben Maske durchgeführt werden.

8. Verfahren nach Anspruch 6, **dadurch gekennzeichnet, daß** die Belichtungen der Haftschicht und der Epoxyharzschicht mit Laserdirektschreiberverfahren durchgeführt werden.

9. Verfahren zur Herstellung von Verbundmaterial aus Substrat, Metall und photostrukturierbaren Epoxyharzen, **dadurch gekennzeichnet,**
**daß** auf das Substrat eine Metallschicht mit Mikro-Topographie aufgebracht, und
**daß** auf die Metallschicht als Haftschicht eine Polyimidschicht mit einer Dicke < 1 µm aufgebracht wird, auf die anschließend das Epoxyharz aufgetragen wird.

10. Verfahren nach Anspruch 9, **dadurch gekennzeichnet, daß** ein Substrat aus Silizium, Glas, Kunststoff oder Keramik verwendet wird.

11. Verfahren nach einem der Ansprüche 9 oder 10, **dadurch gekennzeichnet,** däß eine Metallschicht oder Metallschichten aus Titan, Kupfer, Nickel oder Silber verwendet wird/werden.

12. Verfahren nach einem der Ansprüche 9 bis 11, **dadurch gekennzeichnet, daß** die Metallschicht vor dem Aufbringen der Polyimidschicht bei 200°C bis 300°C für eine Zeitdauer von 10 bis 60 min dehydriert wird.

13. Verfahren nach einem der Ansprüche 9 bis 12, **dadurch gekennzeichnet, daß** die Polyimidschicht mittels eines Spincoat-Prozesses auf die dehydrierte Metallschicht aufgetragen wird.

14. Verfahren nach einem der Ansprüche 9 bis 13, **dadurch gekennzeichnet, daß** auf die Metallschicht ein Precurser-Material aufgebracht wird, das anschließend einer Wärmebehandlung zur Ausbildung des Polyimids unterworfen wird.

15. Verfahren nach Anspruch 14, **dadurch gekennzeichnet, daß** die Wärmebehandlung 0,5 bis 2 min bei 80°C bis 100°C und 2 bis 4 min bei 100°C bis 120°C durchgeführt wird.

## Claims

1. Use of polyimide or polyimide mixtures for an adhesive layer with a thickness of < 1 µm between photostructurable epoxy resins and metal or silicon.

2. Use according to Claim 1, photostructurable polyimide being used.

3. Lithographic method for producing microcomponents with component structures in the submillimetre range, in which a structurable adhesive layer is applied to a metallic layer and a layer of photostructurable epoxy resin is applied to the adhesive layer, the epoxy resin is structured by means of selective exposure and removal of the unexposed regions and, after removing the adhesive layer from the intermediate spaces between the resin structures, the intermediate spaces are filled with metal by means of a galvanic method, **characterized in that** an adhesive layer of polyimide or a polyimide mixture with a thickness of < 1 µm is used.

4. Method according to Claim 3, **characterized in that**, after the structuring of the epoxy resin, the uncovered adhesive layer is removed by plasma etching to uncover the metal layer.

5. Method according to Claim 3, **characterized in that** a photostructurable polyimide is used as the polyimide.

6. Lithographic method for producing microcomponents with component structures in the submillimetre range, in which a structurable adhesive layer is applied to a metallic layer and a layer of photostructurable epoxy resin is applied to the adhesive layer, the epoxy resin is structured by means of selective exposure and removal of the unexposed regions and the intermediate spaces between the resin structures are filled with metal by means of a galvanic method, **characterized in that** an adhesive layer of photostructurable polyimide or a photostructurable polyimide mixture with a thickness of < 1 µm is used, and
- **in that**, before application of the epoxy resin, the adhesive layer is selectively exposed and the unexposed regions are removed,
- **in that** the epoxy resin is subsequently applied over the full surface area to the adhesive layer and the uncovered metallic layer,
- **in that** substantially those regions of the epoxy resin under which the adhesive layer is located are exposed, and
- **in that** subsequently the unexposed regions of the epoxy resin are removed to uncover the metal layer.

7. Method according to Claim 6, **characterized in that** the exposures of the adhesive layer and of the epoxy resin layer are carried out with the same mask.

8. Method according to Claim 6, **characterized in that** the exposures of the adhesive layer and of the epoxy resin layer are carried out by laser direct-writing methods.

9. Method for producing composite material from a substrate, metal and photostructurable epoxy resins, **characterized**
- **in that** a metal layer with microtopography is applied to the substrate, and
- **in that** a polyimide layer with a thickness of < 1 µm is applied to the metal layer as an adhesive layer, to which the epoxy resin is subsequently applied.

10. Method according to Claim 9, **characterized in that** a substrate of silicon, glass, plastic or ceramic is used.

11. Method according to either of Claims 9 and 10, **characterized in that** a metal layer or metal layers of titanium, copper, nickel or silver is/are used.

12. Method according to one of Claims 9 to 11, **characterized in that**, before the application of the polyimide layer, the metal layer is dehydrated at 200°C to 300°C for a time period of 10 to 60 minutes.

13. Method according to one of Claims 9 to 12, **characterized in that** the polyimide layer is applied to the dehydrated metal layer by means of a spin-coating process.

14. Method according to one of Claims 9 to 13, **characterized in that** a precursor material is applied to the metal layer and is subsequently subjected to a heat treatment to form the polyimide.

15. Method according to Claim 14, **characterized in that** the heat treatment is carried out for 0.5 to 2 minutes at 80°C to 100°C and for 2 to 4 minutes at 100°C to 120°C.

## Revendications

1. Utilisation de polyimide ou de mélanges de polyimides pour une couche adhésive d'une épaisseur < 1 µm entre des résines d'époxy photostructurables et du métal ou du silicium.

2. Utilisation selon la revendication 1, dans laquelle on utilise un polyimide photostructurable.

3. Procédé lithographique de fabrication de microcomposants structurés dans la plage inférieure au millimètre, dans lequel une couche adhésive structurable est appliquée sur une couche métallique et une couche de résine époxy photostructurable est appliquée sur la couche adhésive, dans lequel la résine époxy est structurée par éclairage sélectif et enlèvement des zones non éclairées et, après enlèvement de la couche adhésive des espaces intermédiaires situés entre les structures de résine, les espaces intermédiaires sont remplis de métal par un procédé galvanique, **caractérisé en ce que** l'on utilise une couche adhésive en polyimide ou en un mélange de polyimides dont l'épaisseur est < 1 µm.

4. Procédé selon la revendication 3, **caractérisé en ce qu'**après la structuration de la résine époxy, la couche adhésive libérée est enlevée par gravure au plasma pour libérer la couche métallique.

5. Procédé selon la revendication 3, **caractérisé en ce** comme polyimide, on utilise un polyimide photostructurable.

6. Procédé photolithographique de fabrication de microcomposants qui présentent des structures dans la plage inférieure au millimètre, dans lequel une couche adhésive structurable est appliquée sur une couche métallique et une couche de résine époxy photostructurable est appliquée sur la couche adhésive, la résine époxy est structurée par éclairage sélectif et enlèvement des zones non éclairées et les espaces intermédiaires situés entre les structures de résine sont remplis de métal par un procédé galvanique, **caractérisé en ce que** l'on utilise une couche adhésive en polyimide ou en un mélange de polyimides dont l'épaisseur est < 1 µm et **en ce que**
la couche adhésive est éclairée sélectivement avant l'application de la résine époxy et les zones non éclairées sont enlevées,
la résine époxy est ensuite appliquée sur toute la surface de la couche adhésive et la couche métallique libérée est appliquée,
les zones éclairées de la résine époxy sont essentiellement celles en dessous desquelles se trouve la couche adhésive et
les zones non éclairées de la résine époxy sont enlevées pour libérer la couche métallique.

7. Procédé selon la revendication 6, **caractérisé en ce que** l'éclairage de la couche adhésive et celui de la couche de résine époxy sont réalisés avec les mêmes masques.

8. Procédé selon la revendication 6, **caractérisé en ce que** l'éclairage de la couche adhésive et celui de la couche de résine époxy sont réalisés par des procédés d'écriture directe par laser.

9. Procédé de fabrication d'un matériau composite constitué d'un substrat, d'un métal et de résines époxy photostructurables, **caractérisé en ce que**
on applique par microtopographie une couche métallique sur le substrat et
sur la couche métallique, on applique comme couche adhésive une couche de polyimide dont l'épaisseur < 1 µm et sur laquelle on applique ensuite la résine époxy.

10. Procédé selon la revendication 9, **caractérisé en ce qu'**on utilise un substrat en silicium, en verre, en matière synthétique ou en céramique.

11. Procédé selon l'une des revendications 9 ou 10, **caractérisé en ce que** l'on utilise une couche métallique ou des couches métalliques en titane, cuivre, nickel ou argent.

12. Procédé selon l'une des revendications 9 à 11, **caractérisé en ce que** la couche métallique est déshydrogénée pendant une durée de 10 à 60 min et entre 200°C et 300°C avant l'application de la couche de polyimide.

13. Procédé selon l'une des revendications 9 à 12, **caractérisé en ce que** la couche de polyimide est appliquée sur la couche métallique déshydrogénée par un procédé de revêtement par centrifugation.

14. Procédé selon l'une des revendications 9 à 13, **caractérisé en ce que** l'on applique sur la couche métallique un matériau précurseur qui subit ensuite un traitement thermique pour former le polyimide.

15. Procédé selon la revendication 14, **caractérisé en ce que** le traitement thermique est réalisé pendant 0,5 à 2 min entre 80 °C et 100 °C et pendant 2 à 4 min entre 100°C et 120°C.
